(19) Europäisches Patentamt
European Patent Office
Office européen des brevets

(11) **EP 3 224 944 B1**

(12) **EUROPÄISCHE PATENTSCHRIFT**

(45) Veröffentlichungstag und Bekanntmachung des Hinweises auf die Patenterteilung:
**30.01.2019 Patentblatt 2019/05**

(21) Anmeldenummer: **15797692.9**

(22) Anmeldetag: **23.11.2015**

(51) Int Cl.:
*H03F 1/56* (2006.01)     *H03F 3/00* (2006.01)
*H03F 3/45* (2006.01)     *G11C 27/02* (2006.01)

(86) Internationale Anmeldenummer:
**PCT/EP2015/077326**

(87) Internationale Veröffentlichungsnummer:
**WO 2016/083288 (02.06.2016 Gazette 2016/22)**

(54) **SC-VERSTÄRKERSCHALTUNG**

SC AMPLIFIER CIRCUIT

CIRCUIT D'AMPLIFICATION SC

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **28.11.2014 EP 14195460**

(43) Veröffentlichungstag der Anmeldung:
**04.10.2017 Patentblatt 2017/40**

(73) Patentinhaber: **Elmos Semiconductor Aktiengesellschaft
44227 Dortmund (DE)**

(72) Erfinder:
• **RAEHSE, Norbert
13347 Berlin (DE)**
• **ARNOLD, Rüdiger
10405 Berlin (DE)**

(74) Vertreter: **dompatent von Kreisler Selting Werner - Partnerschaft von Patent- und Rechtsanwälten mbB
Deichmannhaus am Dom
Bahnhofsvorplatz 1
50667 Köln (DE)**

(56) Entgegenhaltungen:
WO-A1-96/10827         US-A- 5 142 238
US-A1- 2008 024 351     US-A1- 2010 079 204
US-A1- 2013 162 455     US-B1- 7 518 439

**Beschreibung**

Die Erfindung betrifft eine SC-(Switched-Capacitor-)Verstärkerschaltung zum Verstärken einer an einem Eingang anliegenden Eingangsspannung um einen Verstärkungsfaktor und zum Ausgeben der verstärkten Eingangsspannung an einem Ausgang während eines Schaltzyklus.

SC-Verstärkerschaltungen sind grundsätzlich bekannt. Sie bieten eine Offset-Kompensation und eine nahezu optimale Unterdrückung des 1/f-Rauschens, so dass sie sich insbesondere für Eingangsspannungen sehr geringer Amplitude eignen, wenn diese hochauflösend verstärkt werden sollen. Dies ist beispielsweise der Fall bei Messsignalquellen, deren Messsignalamplitude äußerst gering ist. Ein Beispiel für eine derartige Messsignalquelle ist ein MEMS-Druck- oder Beschleunigungssensor. Alternativ können auch an Wheatstoneschen Messbrücken-Spannungssignale mit lediglich geringer Amplitude anstehen.

SC-Verstärkerschaltungen werden Schaltzyklus-gesteuert betrieben, wobei ein Schaltzyklus mindestens zwei Intervalle ausweist, von denen das eine zum Aufladen einer Eingangskapazität und das andere zum Ent- bzw. Umladen der Eingangskapazität dient. Es ist nicht ausgeschlossen, dass der Schaltzyklus noch weitere Intervalle umfasst.

SC-Verstärkerschaltungen verwenden also eine Eingangskapazität. Der Zusammenhang zwischen Eingangskapazität, Schaltfrequenz $f_S$, Bandbreite und maximal erreichbarer Auflösung (Effective Number Of Bits, ENOB) aufgrund thermischen Rauschens ist grundlegend bekannt. Um bei gegebener Bandbreite BW die Auflösung ENOB um $\Delta ENOB=1$ Bit zu erhöhen, muss man entweder die Eingangskapazität $C_S$ oder die Abtastfrequenz $f_S$ vervierfachen:

$$\Delta ENOB = log2\left(\sqrt{\frac{C_S \cdot f_S}{BW}}\right)$$

Bei Schaltungen wie dem invertierenden oder nicht-invertierenden SC-Verstärker wird die Abtast-Eingangskapazität $C_S$ bei jedem Takt entladen und muss von der Eingangssignalquelle $V_{SIG}$ mit Innenwiderstand $R_{SIG}$ über den Abtast-Schalter-Widerstand $R_S$ wieder aufgeladen werden.

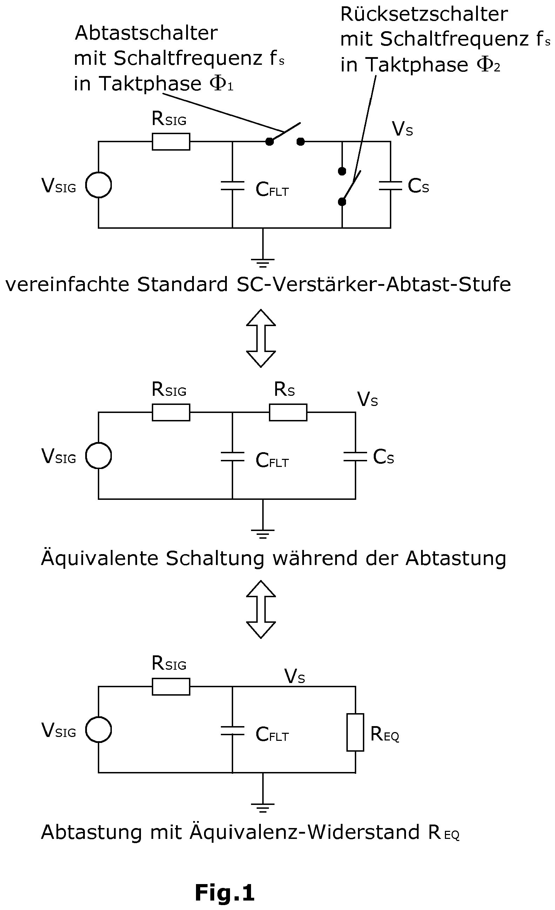

In Fig. 1 ist die Abtast-Konfiguration eines abtastenden Systems mit Abtasten und Ladungs-Rücksetzen eines Standard SC-Verstärkers zu sehen.

Durch den Innenwiderstand der Signalquelle und den Abtast-Schalter-Widerstand ist die Menge der Ladung, die entnommen werden darf, jedoch begrenzt:

- Die Abtast-Kapazität muss innerhalb einer halben Taktperiode aus der Eingangssignalquelle auf die gewünschte Auflösung einschwingen. Ungenügendes Einschwingen entspricht einem Verstärkungsfehler. Dies führt zu einer Mindest-Einschwingzeit, die die Taktfrequenz $f_S$ begrenzt. Ohne Filterkapazität $C_{FLT}=0$ ergibt sich

$$f_{S,keinFilter} \leq \frac{0.72}{GAB \cdot (R_{SIG} + R_S) \cdot C_S,}$$

wobei GAB die absolute Bitgenauigkeit (Gain Accuracy in Bit) des Verstärkungsfehlers darstellen soll.

- Bei Verwendung einer Filterkapazität $C_{FLT}$ parallel zum Eingang als Anti-Aliasing-Filter wirkt die Abtast-Schaltung aus $C_S$ und $R_S$ mit Abtasten und Rücksetzen wie ein Lastwiderstand mit äquivalentem Wert von $R_{EQ}=1/f_S*C_S$). Dieser Lastwiderstand führt zu einem Verstärkungsfehler durch den Spannungsteiler $R_{SIG}$ und $R_{EQ}$. Dadurch ist Abtastfrequenz $f_S$ ebenfalls limitiert:

$$f_{S,mitFilter} \leq \frac{1}{2^{GAB} \cdot R_{SIG} \cdot C_S}$$

Hierbei ist zu beachten, dass die Frequenz $f_{S, mit Filter}$ mit Anti-Alias-Filter um ein Vielfaches, eben $2^{GAB}$, kleiner ist als $f_{S, kein Filter}$.

Somit kann die Eingangskapazität oder Schaltfrequenz nicht beliebig erhöht werden und es ergibt sich eine systemische Grenze der erreichbaren Auflösung ENOB bei gegebener Brandbreite BW.

Schaltungsvarianten wie "Resettable Gain Circuit" oder "Capacitive-Reset Gain Circuit" kompensieren den Offset des Verstärkers, entladen die Eingangskapazität jedoch auch komplett, da sie auf der invertierenden oder nicht-invertierenden Architetur basieren (siehe David A. Johns, Ken Martin "Analog Intergrated Circuit Design", John Wiley & Sons, Inc. S. 431, 1997).

Ein gewisser Nachteil bei SC-Verstärkerschaltungen ist darin zu sehen, dass am Ende eines Schaltzyklus und mit Beginn des nächsten Schaltzyklus die Eingangskapazität wieder aufgeladen werden muss, und zwar mit Ladung, die von der Messsignalquelle bereitgestellt werden muss. Dies belastet die Messsignalquelle, was je nach Messsignalamplitude von Nachteil ist.

Eine SC-Verstärkerschaltung ist nach dem Oberbegriff des Anspruch 1 z. B. aus WO-A-96/10827 A1 bekannt. In den Fign. 1 und 3 dieser Schrift sollen offset-kompensierte SC-Verstärkerschaltungen gezeigt sein, wobei anzumerken ist, dass für die offset-Kompensation einiger schaltungstechnischer Aufwand betrieben werden muss. Den rein rechnerisch bleibt der Offset am Ausgang der Schaltung erhalten ($V_{out} = C_1/C_2 \times V_{in} + V_{offset}$), jedoch nicht an deren Eingang, was bei großem Verstärkungsfaktor ein Vorteil ist. Der verbleibende Offset kann in Schaltphase 1 gemessen werden und mit Aufwand in einer nachfolgenden Verarbeitung subtrahiert werden.

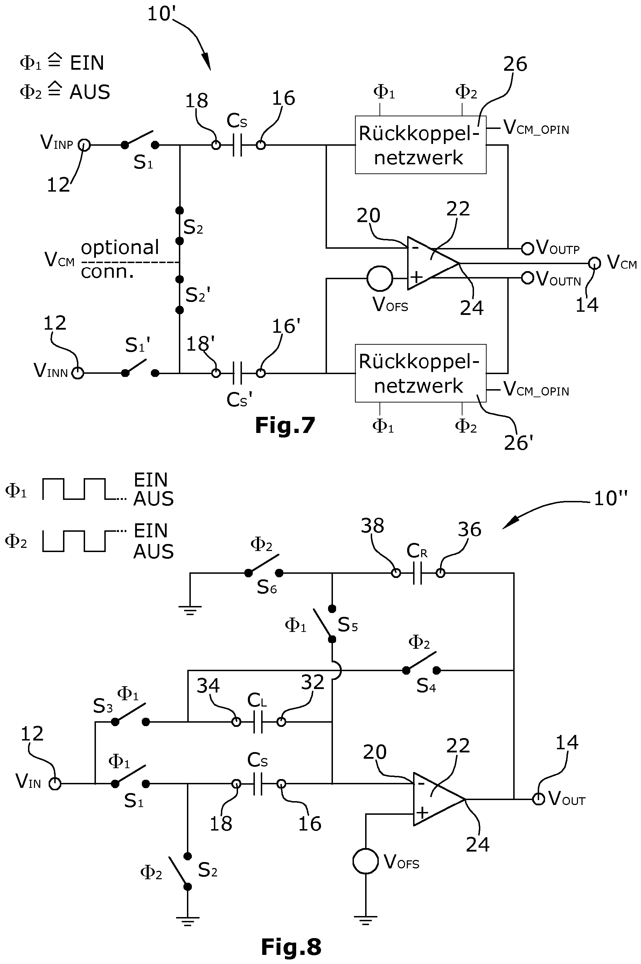

Ein gewisser Nachteil dieser bekannten Schaltung kann auch sein, dass zur Ladungsrückspeisung ein weiterer Kondensator $C_3$ benötigt werden könnte, welcher zu den Kondensatoren $C_1$ und $C_2$ "passen" muss. Eine toleranzbedingt nahezu unvermeidbare Fehlanpassung schränkt die "Güte" der Ladungsrückgewinnung (weiter unten mit "Kappa" bezeichnet) stark ein. Der Kondensator C benötigt ferner Platz, da er eine ähnliche Dimensionierung haben muss wie die Kondensatoren $C_1$ und $C_2$. Die Möglichkeiten zur Einstellung des Verstärkungsfaktors ($C_1/C_2$-Verhältnis) sind ebenfalls recht eingeschränkt. Dieser Nachteil wird in der Schrift angesprochen. Deshalb ist in Fig. 7 der Schrift eine weitere Ausprägung dargestellt. Unter Zuhilfenahme eines weiteren Operationsverstärkers ist es möglich, die Ladungskompensationskapazität wesentlich kleiner zu halten und diesbezüglich unabhängiger von der Verstärkereinstellung zu sein. Allerdings ist diese Variante nicht offset-kompensiert, wofür in der Schrift weitere Techniken unter Zuhilfenahme weiterer Operationsverstärker vorgeschlagen werden.

Aufgabe der Erfindung ist es daher, eine SC-Verstärkerschaltung zu schaffen bzw. derart zu betreiben, dass die Ladung zum Wiederaufladen der Eingangskapazität nicht bzw. nur kaum aus der Messsignalquelle entnommen werden muss.

Zur Lösung dieser Aufgabe wird mit der Erfindung eine SC-Verstärkerschaltung vorgeschlagen zum Verstärken einer an einem Eingang anliegenden Eingangsspannung einer Messsignalquelle um einen Verstärkungsfaktor und zum Ausgeben der verstärkten Eingangsspannung an einem Ausgang während eines Schaltzyklus, der mindestens ein Aufladeintervall zum Aufladen einer Eingangskapazität und mindestens ein Entladeintervall zum Entladen der Eingangskapazität umfasst, wobei die SC-Verstärkerschaltung versehen ist mit

- einem Schaltungseingangsanschluss für die zu verstärkende, von der Messsignalquelle, gelieferten Eingangsspannung,
- einem Verstärker mit einem Verstärkereingangsanschluss und einem Verstärkerausgangsanschluss,
- wobei die Eingangskapazität mit dem Verstärkereingangsanschluss verbunden ist und in dem Aufladeintervall mit dem Schaltungseingangsanschluss verbindbar sowie in dem Entladeintervall von dem Schaltungseingangsanschluss entkoppelbar ist,
- einem Rückkoppelnetzwerk, das zwischen den Verstärkerausgangsanschluss und den Verstärkereingangsanschluss geschaltet ist, und
- einer Wiederaufladequelle zum Bereitstellen eines Ladestroms zum Aufladen der Eingangskapazität, wobei die Wiederaufladequelle in dem Aufladeintervall die Eingangskapazität auflädt und in dem Entladeintervall hinsichtlich eines Aufladens der Eingangskapazität wirkungslos geschaltet ist,
- wobei die Wiederaufladequelle eine Umladekapazität ist, die einen mit dem Verstärkereingangsanschluss verbundenen ersten Anschluss und einen zweiten Anschluss aufweist, der wechselweise entweder über einen dritten Schalter mit dem Verstärkereingangsanschluss oder über einen vierten Schalter mit dem Verstärkerausgangsanschluss verbindbar ist, wobei in dem Aufladeintervall der dritte Schalter geschlossen sowie der vierte Schalter offen und in dem Entladeintervall der dritte Schalter offen sowie der vierte Schalter geschlossen ist.

Die zuvor genannte Aufgabe wird erfindungsgemäß auch gelöst durch ein Verfahren zum Betreiben einer SC-Verstärkerschaltung zum Verstärken einer an einem Eingang anliegenden Eingangsspannung einer Messsignalquelle um einen Verstärkungsfaktor und zum Ausgeben der verstärkten Eingangsspannung an einem Ausgang während eines Schaltzyklus, der mindestens ein Aufladeintervall zum Aufladen einer Eingangskapazität und mindestens ein Entladeintervall zum Entladen der Eingangskapazität umfasst,

- wobei die Eingangskapazität in dem Aufladeintervall des Schaltzyklus mit Ladung aufgeladen wird, die durch eine außerhalb der Messsignalquelle und insbesondere innerhalb der SC-Verstärkerschaltung angeordnete Wiederaufladequelle erzeugt wird, und
- wobei die Wiederaufladequelle eine Umladekapazität ist, die einen mit dem Verstärkereingangsanschluss verbundenen ersten Anschluss und einen zweiten Anschluss aufweist, der wechselweise entweder über einen dritten Schalter mit dem Verstärkereingangsanschluss oder über einen vierten Schalter mit dem Verstärkerausgangsanschluss verbindbar ist, wobei in dem Aufladeintervall der dritte Schalter geschlossen sowie der vierte Schalter offen und in dem Entladeintervall der dritte Schalter offen sowie der vierte Schalter geschlossen ist.

Die erfindungsgemäße SC-Verstärkerschaltung verfügt über eine Wiederaufladequelle, die einen Ladestrom bereitstellt, der innerhalb des Aufladeintervalls dazu dient, die Eingangskapazität aufzuladen. Dadurch kann eine Belastung der Signalquelle vermieden werden. Die Signalquelle "sieht" also einen hochohmigen SC-Verstärkerschaltungseingang, wodurch auch Eingangssignale mit geringster Amplitude hochauflösend verstärkt werden können.

Gemäß der Erfindung wird eine Umladekapazität eingesetzt, die die einen mit dem Verstärkereingangsanschluss verbundenen ersten Anschluss und einen zweiten Anschluss aufweist, der wechselweise entweder über einen dritten Schalter mit dem Verstärkereingangsanschluss oder über einen vierten Schalter mit dem Verstärkerausgangsanschluss verbindbar ist, wobei in dem Aufladeintervall der dritte Schalter geschlossen sowie der vierte Schalter offen und in dem Entladeintervall der dritte Schalter offen sowie der vierte Schalter geschlossen ist.

In vorteilhafter Ausgestaltung der Erfindung kann vorgesehen sein, dass die Eingangskapazität einen mit dem Verstärkereingangsanschluss verbundenen ersten Anschluss und einen zweiten Anschluss aufweist, der wechselweise entweder über einen ersten Schalter mit dem Schaltungseingangsausschluss oder über einen zweiten Schalter mit Masse verbindbar ist, wobei in dem Aufladeintervall der erste Schalter geschlossen sowie der zweite Schalter offen und in dem Entladeintervall der erste Schalter offen sowie der zweite Schalter geschlossen ist, und dass die Wiederaufladequelle in dem Aufladeintervall Ladestrom in den zweiten Anschluss der Eingangskapazität einspeist.

Gemäß einer ersten, alternativen Weiterbildung der Erfindung wird als Wiederaufladequelle statt der Umladekapazität und deren oben beschriebenen wechselweisen Vorschaltung eine Stromquelle eingesetzt, die mit dem zweiten Anschluss der Eingangskapazität verbunden und während des Aufladeintervalls aktiv sowie während des Entladeintervalls inaktiv geschaltet ist oder deren Ladestrom in dem Aufladeintervall dem zweiten Anschluss der Eingangskapazität zuführbar und in dem Entladeintervall statt dem zweiten Anschluss der Eingangskapazität über einen anderen Schaltungspunkt ableitbar ist. Diese Stromquelle ist lediglich in dem Aufladeintervall insoweit aktiviert, als dass ihr Ladestrom die Eingangskapazität mit Ladung speist. Die Wiederaufladequelle kann im Entladeintervall entweder inaktiv geschalten sein oder aber im Entladeintervall fließt der Ladestrom über einem anderen Schaltungspunkt ab, was allerdings hinsichtlich der Energiebilanz von Nachteil ist, da elektrische Energie, ohne dass sie sinnvoll genutzt wird, abgezweigt wird.

In weiterer vorteilhafter Ausgestaltung der Erfindung kann eine Rückkoppelkapazität vorgesehen sein, die die einen mit dem Verstärkerausgangsanschluss verbundenen ersten Anschluss und einen zweiten Anschluss aufweist, der wechselweise entweder über einen fünften Schalter mit dem Verstärkereingangsanschluss oder über einen sechsten Schalter mit Masse verbindbar ist, wobei in dem Aufladeintervall der fünfte Schalter geschlossen sowie der sechste Schalter offen und in dem Entladeintervall der fünfte Schalter offen sowie der sechste Schalter geschlossen ist. Durch den Einbau dieser Rückkoppelkapazität kann der Ausgang der SC-Verstärkerschaltung bzw. der Ausgang des Verstärkers der SC-Verstärkerschaltung in beiden Phasen bzw. Intervallen auf ähnlichem Potenzial gehalten werden, wodurch dieser Ausgang einem geringeren Spannungshub ausgesetzt ist, was letztendlich für das Verhalten der SC-Verstärkerschaltung von Vorteil ist.

Die Erfindung wird nach folgend an Hand verschiedener Ausführungsbeispiele und unter Bezugnahme auf die Zeichnung näher erläutert. Im Einzelnen zeigen dabei:

Fig. 1        schematisch ein abtastendes System mit Abtasten-Rücksetzen eines Standard SC-Verstärkers,

Fig. 2        ein erstes Ausführungsbeispiel der Erfindung als Single-Ended-Variante,

Fig. 3        die Schaltung gemäß Fig. 2 in der Phase, in der $\Phi_1$ high und $\Phi_2$ low ist und damit sich die von Fi1 und Fi2 angesteuerten Schalter dementsprechend im EIN- bzw. AUS-Zustand befinden,

Fig. 4        die Schaltung gemäß Fig. 2 in den Phasen, in denen $\Phi_1$ low und $\Phi_2$ high ist und damit die entsprechenden Schalter ein-bzw. ausgeschaltet sind,

Fig. 5        eine volldifferentielle Schaltungsvariante der Erfindung,

Fign. 6 und 7   die Situationen, in denen die verschiedenen Schalter der Schaltung gemäß Fig. 5 wechselweise ein-bzw. ausgeschaltet sind,

Fig. 8        ein weiteres Ausführungsbeispiel einer SC-Verstärkerschaltung nach der Erfindung und

Fign. 9 und 10   die Schaltungskonfigurationen, in denen die von $\Phi_1$ angesteuerten Schalter ein- und die von $\Phi_2$ an-

gesteuerten Schalter ausgeschaltet bzw. die von $\Phi_1$ angesteuerten Schalter ausgeschaltet und die von $\Phi_2$ angesteuerten Schalten eingeschaltet sind.

In den Fign. 1 bis 3 sind ein erstes Ausführungsbeispiel einer SC-Verstärkerschaltung 10 sowie die sich wechselweise Ansteuerung der einzelnen Schalter ergebenden Schaltungskonfigurationen dieser SC-Verstärkerschaltung 10 gezeigt. Die Verstärkerschaltung 10 weist einen Schaltungseingangsanschluss 12 und einen Schaltungsausgangsanschluss 14 auf. Am Schaltungseingangsanschluss 12 liegt beispielsweise die Messspannung einer Kleinstsignal-Messsignalquelle (nicht dargestellt) an, die Messsignale mit lediglich geringer Amplitude liefert. Entscheidend für derartige Messsignalquellen ist, dass sie durch eine Verstärkerschaltung nicht bzw. lediglich nicht äußerst geringem Maße belastet werden. Die Verstärkerschaltung sollte also insoweit hochohmig sein.

Erfindungsgemäß wird dies SC-Verstärkerschaltung 10 sowie bei den anderen Ausführungsbeispielen, die weiter unten noch beschrieben werden, dadurch erreicht, dass in dem Aufladeintervall des Schaltzyklus der SC-Verstärkerschaltung die Eingangskapazität aktiv aufgeladen wird, und zwar nicht über die Messsignalquelle.

Mit dem Schaltungseingangsanschluss 12 der SC-Verstärkerschaltung 10 ist über einen ersten Schalter $S_1$ eine Eingangskapazität $C_S$ koppelbar. Diese Eingangskapazität $C_S$ weist einen ersten Anschluss 16 und einen zweiten Anschluss 18 auf. Der zweite Anschluss 18 ist über den Schalter $S_1$ mit dem Schaltungseingangsanschluss 12 verbunden. Mit dem ersten Anschluss 16 der Eingangskapazität $C_S$ ist der invertierende Eingang eines Verstärkers 22 verbunden, dessen nicht-invertierende Verstärkereingangsanschluss 20 mit einem Spannungssignal $V_{OFS}$ beaufschlagt ist. Der Verstärkerausganganschluss 24 ist mit dem Schaltungsausgangsanschluss 14 verbunden und über ein Rückkoppelnetzwerk 26 zum Verstärkereingangsanschluss 20 rückgekoppelt.

Zwischen der Eingangskapazität $C_S$ und dem Schalter $S_1$ ist ein zweiter Schalter $S_2$ mit Masse verbunden. Parallel zu diesem zweiten Schalter $S_2$ liegt eine Wiederaufladequelle 28 die in diesem Ausführungsbeispiel als Ladestromquelle 30 ausgebildet ist.

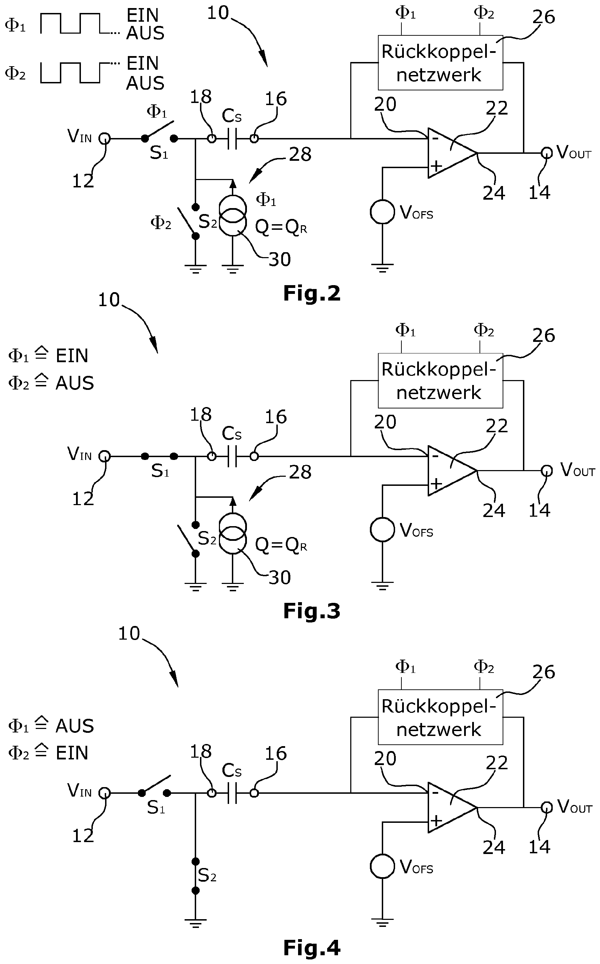

Durch $\Phi_1$ und $\Phi_2$ ist in der Darstellung der SC-Verstärkerschaltung 10 nach Fig. 2 angedeutet, dass die Schalter $S_1$ und $S_2$ in unterschiedlichen Intervallen des Schaltzyklus wechselweise ein- und ausgeschaltet sind. Die Steuersignale $\Phi_1$ und $\Phi_2$ werden von einer (nicht dargestellten) Ansteuereinheit erzeugt, die zur Steuerung der SC-Verstärkerschaltung 10 dient, so dass diese am Schaltungseingangsanschluss 12 anstehendes Signal um einen vorgebbaren Verstärkungsfaktor verstärkt und am Schaltungsausgangsanschluss 14 verstärkt ausgeht. So ist der Schalter $S_1$ während des Aufladeintervalls geschlossen, wobei die Ladestromquelle 30 in diesem Aufladeintervall einen Aufladestrom für die Eingangskapazität $C_S$ liefert. Während des Aufladeintervalls ist der zweite Schalter $S_2$ geschlossen. Diese Situation ist in Fig. 3 gezeigt.

Im Entladeintervall kehren sich die Schaltzustände der beiden Schalter $S_1$ und $S_2$ um, wie es in Fig. 4 gezeigt ist.

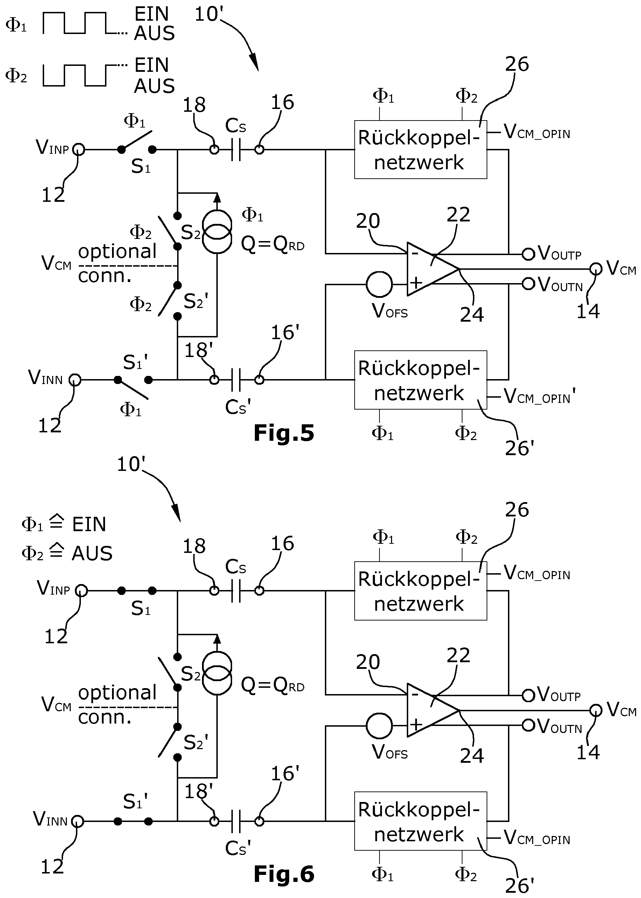

In den Fign. 5 bis 7 ist eine volldifferentielle Variante einer SC-Verstärkerschaltung 10' gezeigt. Die einander korrespondierenden Bauteile sind mit jeweils gestrichelten Größen bezeichnet. Im Übrigen arbeitet die Schaltung entsprechend der SC-Verstärkerschaltung 10 der Fign. 2 bis 4, weshalb an dieser Stelle auf die volldifferentielle Variante nicht weiter eingegangen werden soll.

In den Fign. 8 bis 10 ist ein letztes Ausführungsbeispiel einer SC-Verstärkerschaltung 10" gezeigt, und zwar als single-ended-Version. Soweit die Elemente dieser SC-Verstärkerschaltung 10" denjenigen der SC-Verstärkerschaltung 10 der Fign. 2 bis 3 entsprechen bzw. gleichen, sind sie in den Fign. 8 bis 10 mit den gleichen Bezugszeichen wie in den Fign. 2 bis 4 bezeichnet. Es versteht sich von selbst, dass diese single-ended-Version nach Fign. 8 bis 10 auch als volldifferentielle Variante ausführbar ist (entsprechend Fign. 5 bis 7, die die single-ended-Variante nach Fign. 2 bis 4 in volldifferentieller Form zeigen).

Bei dem Ausführungsbeispiel gemäß den Fign. 8 bis 10 erfolgt Wiederaufladung der Eingangskapazität $C_S$ in dem Aufladeintervall durch eine Umladekapazität $C_L$. Und diese Umladekapazität $C_L$ ist während des Aufladeintervalls parallel zur Eingangskapazität $C_S$ geschaltet, was durch die Verbindung dieser Umladekapazität $C_L$ über einen dritten Schalter $S_3$ mit dem Schaltungseingangsanschluss 12 realisiert ist. Die Umladekapazität $C_L$ ist im Übrigen an ihrem anderen Anschluss mit dem Verstärkereingangsanschluss 20 verbunden.

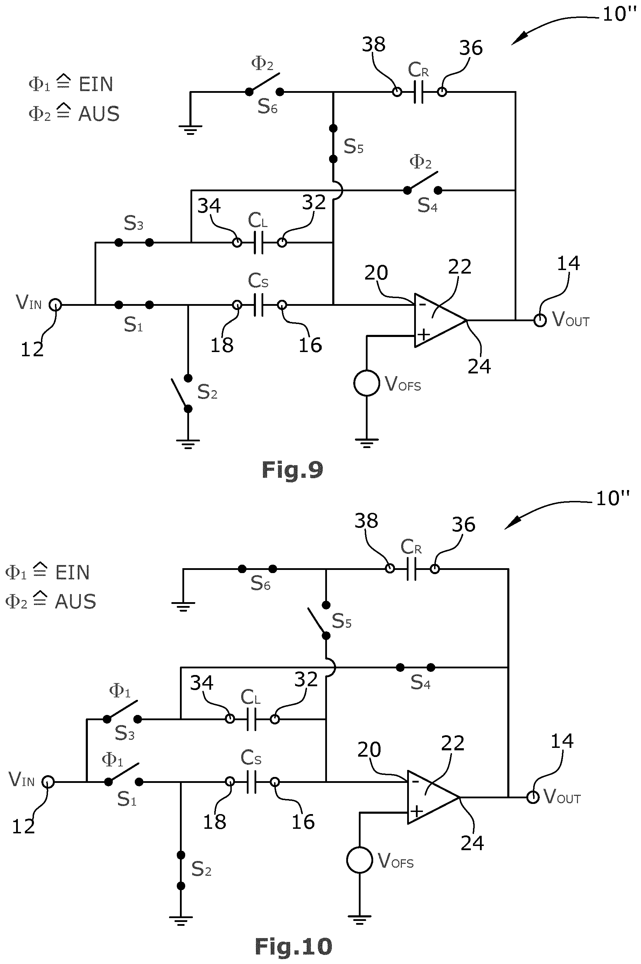

Die Umladekapazität $C_L$ kann in denjenigen Phasen, in denen sie vom Schaltungseingangsanschluss entkoppelt ist, also in dem Entladeintervall, über einen in dieser Phase geschlossenen vierten Schalter $S_4$ mit dem Verstärkerausgangsanschluss 24 des Verstärkers 22 verbunden werden. Dadurch stellt sich in den verschiedenen Phasen dies Schaltzyklus, also beispielsweise im Aufladeintervall die Situation nach Fig. 9 und im Entladeintervall die Situation gemäß Fig. 10 ein. Mit anderen Worten ist also der erste Anschluss 32 der Umladekapazität $C_L$ mit dem Verstärkereingangsanschluss 20 verbunden, während der zweite Anschluss 34 der Umladekapazität $C_L$ über den dritten Schalter $S_3$ wahlweise mit dem Schaltungseingangsanschluss 12 und im Wechsel dazu über den vierten Schalter $S_4$ mit dem Verstärkerausgangsanschluss 24 verbunden ist.

Zusätzlich zu den zuvor erwähnten Kapazitäten und Schaltern weist die SC-Verstärkerschaltung 10" noch eine Rückkoppelkapazität $C_R$, deren erster Anschluss 36 mit dem Verstärkerausgangsanschluss 24 verbunden ist und dessen Anschluss 38 über einen fünften Schalter $S_5$ und über einen sechsten Schalter $S_6$ wechselweise mit dem Verstärker-

eingangsanschluss 20 oder mit Masse verbunden ist.

Die Ansteuerung der zuvor erwähnten sechs Schalter der SC-Verstärkerschaltung 10" erfolgt mittels der Ansteuersignale $\Phi_1$ und $\Phi_2$, wie es in Fig. 8 gezeigt ist, so dass sich im Aufladeintervall die Situation gemäß Fig. 9 und im Entladeintervall des Schaltzyklus der SC-Verstärkerschaltung 10" die Situation gemäß Fig. 10 einstellt. Im Aufladeintervall gemäß Fig. 9 erfolgt eine "Wiederverwendung" der in dem Entladeintervall des vorherigen Schaltzyklus "verwendeten" Ladung, und zwar durch parallel Schaltung der Umladekapazität $C_L$ zur Eingangskapazität $C_S$, wodurch die zuvor nach $C_L$ verschobene Ladung nun wieder in beiden Kapazitäten $C_S$ und $C_L$ verteilt ist, die dann gemeinsam sozusagen die Eingangskapazität der SC-Verstärkerschaltung bilden. Hierdurch kommt es zu einer Anpassung an die Ladung des Eingangssignals.

In dem Entladeintervall wird nun gemäß Fig. 10 die Umladekapazität $C_L$ "umgeklappt", wodurch ein Teil der Ladung nun am Ausgang anliegt. Ladung wird nun von der Eingangskapazität $C_S$ zur Umladekapazität $C_L$ verschoben, so dass sich die Gesamtladung beider Kapazitäten nun allein in der Umladekapazität $C_L$ befindet, womit gilt:

$$V_{OUT}=V_{IN}*(C_S+C_L)/C_L$$

Das SC-Verstärkerschaltungskonzept nach der Erfindung wurde in seiner Anwendung auf die Verstärkung eines differentiellen Drucksensor-Signals simuliert. Dieser Drucksensor-Signal hat typischerweise eine Signal-Amplitude von 20 mV und soll offsetfrei digitalisiert werden, und zwar bei größtmöglicher Auflösung über der Bandbreite. Das Drucksensorsignal wird dabei aus einer Widerstandsbrücke gespeist, wodurch sich ein Messsignalquelleninnenwiderstand $R_{SIG}$ ergibt, der sich nicht verringern lässt. Es wurden verschiedene Möglichkeiten untersucht, und zwar auch die Verwendung zeitkontinuierlicher Verstärker mit Offsetkompensation.

SC-Verstärkerschaltungen haben sich dabei als am geeignetsten herausgestellt, da sich ihre Offset- und Gainschwankungen sowie das 1/f-Rauschen zuverlässig verbinden lassen, wobei der Aufwand beherrschbar ist. Es wurden die weiter oben erwähnten systemischen Beschränkungen bei SC-Verstärkerschaltungen, bei denen die Eingangskapazitäten in jedem Schaltzyklus entladen und über die Messsignalquelle wiederaufgeladen werden müssen untersucht. Hierbei stellt sich heraus, dass die Auslösung bei gegebener Bandbreite sich nicht wesentlich über das marktübliche Maß hinaus steigern ließ.

Außerdem ist die Verwendung einer externen Kapazität als Anti-Aliasing-Filter unmöglich. Bei einer sinnvollen Dimensionierung der Eingangskapazität und der Schaltfrequenz würde sich ein Verstärkungsfehler von 4 % ergeben. Von dem Verstärkungsfehler ist ein Teil nicht kalibrierbar. Ein Anti-Aliasing-Filter wäre wünschenswert, um zusätzliches Rauschen zu verhindern und längere Messsignalquellen-Zuleitungen zu ermöglichen.

Wenn die Eingangslast, d. h. die Menge der entnommenen Ladungen pro Takt im Mittel um Faktor Kappa "$\kappa$" reduziert wird, kann die systemische Grenze des Produktes $C_S * f$ erhöht werden:

$$f_{S,keinFilter} \leq \frac{0.72}{(GAB-log2(\kappa))\cdot(R_{SIG}+R_S)\cdot C_S}$$

$$f_{S,mitFilter} \leq \frac{1}{2^{GAB}\cdot R_{SIG}\cdot C_S}$$

Somit kann die Abtast-Frequenz und damit die Bandbreite bei gleicher Auflösung (ohne und mit Filter) um den folgenden Faktor Gewinn$_{fs}$:

$$Gewinn_{f_s,keinFilter}=\frac{GAB}{(GAB-log2(\kappa))}$$

• Keine Anti-Aliasing-Filter-Kapazität:
• Mit Anti-Aliasing-Filter-Kapazität: *Gewinn*$_{fs}$,*mitFilter*=K

oder bei gleicher Brandbreite die Auflösung ENOB um $log2\left(\sqrt{Gewinn_{f_S}}\right)$ erhöht werden.

Es hat sich herausgestellt, dass sich wesentliche Verbesserungen einstellen, wenn das Drucksensorsignal mit einer SC-Verstärkerschaltung nach der Erfindung verstärkt wird, bei der die Ladung der Eingangskapazität am Ende eines Schaltzyklus nahezu vollständig zurückfließt. Somit wird im Mittel kaum Energie am Eingang der SC-Verstärkerschaltung und damit von der Messsignalquelle entnommen.

Bei einer Transistorlevel-Simulation konnte eine Reduktion der entnommenen Ladung um den Faktor $\kappa$=300

erreicht werde. Die Offsetkompensation konnte erhalten werden. Beispiele für die simulierten SC-Verstärkerschaltungen mit Ladungs-Rückgewinnung nach der Erfindung, mit denen die zuvor genannten Verbesserungen erzielt werden konnten, wurden zuvor anhand der Fign. 2 bis 10 beschrieben.

Dabei hat sich herausgestellt, dass in der Taktphase $\Phi_1$ folgende Ladung in den Eingang zurückgespeist wird:

$$Q_R = Q_{RD} = C_S \cdot V_{\mathrm{IN,vor}} \cdot \left(1 - \frac{1}{K}\right) \approx C_S \cdot V_{\mathrm{IN,vor}} \, ,$$

wobei $V_{\mathrm{IN,vor}}$ eine vorherige Eingangsspannung ist (für die Fign. 2 bis 4 und 8 bis 10), mit $V_{\mathrm{IN,vor}} = V_{\mathrm{IN,vor}} - V_{\mathrm{IN,vor}}$ für die volldifferentielle Variante (Fign. 5 bis 7).

Bei der oben genannten Anwendung wäre mit den Parametern

$$C_S = 16\mathrm{pF}$$

$$R_{\mathrm{SIG}} = 5\mathrm{k}\Omega$$

$$f_S = 500\mathrm{kHz}$$

$$BW = 1\mathrm{kHz}$$

$$ENOB = 12\mathrm{Bit}$$

$$GAB_{\mathrm{mit\ Filter}} = 4.6\ \mathrm{Bit\ mit\ Anti\text{-}Alias\text{-}Filter}$$

a) der Gewinn$_{\mathrm{fs,\ kein\ Filter}}$ = ca. 3.1, was möglichen Abtastfrequenzerhöhung von 3.1 oder einer Erhöhung der Auflösung ENOB um ca. 0.8 Bit entspricht, oder

b) der Gewinn$_{\mathrm{fs,\ mit\ Filter}}$ = 300, was einer Erhöhung der Verstärkungsgenauigkeit GAB$_{\mathrm{mit\ Filter}}$ um 8.2 Bit auf 12.8 entspricht.

Damit ist erst der Einsatz eines Anti-Alias-Filter bei einer SC-Schaltung möglich. Anit-Alias-Filter sind u. a. unbedingt notwendig bei einer Hochfrequenzstörung (EMV).

Wesensmerkmal der Erfindung ist es, die Ladung der Eingangskapazität einer SC-Verstärkerschaltung wiederherzustellen, indem sie aus dem vorherigen Schaltzyklus "zurücktransferiert" wird. Hierbei hat sich herausgestellt, dass bei diesem "Ladungs-Recycling" auch eine Offsetkompensation praktikabel möglich ist. Schließlich konnte durch theoretische Überlegungen gezeigt werden, dass fundamentale Begrenzungen der bei herkömmlichen SC-Verstärkerschaltungen erreichbaren Auflösung umgangen werden können, wodurch die Auflösung bei der erfindungsgemäßen SC-Verstärkerschaltung über das am Markt übliche Maß hinaus erhöht werden kann. Die Verwendung eines Anti-Aliasing-Filters wurde ebenfalls ermöglicht, wodurch sich flexiblere Anwendungsmöglichkeiten durch längere Zuleitungen der Messsignalquelle ergeben.

**Bezugszeichenliste**

10 SC-Verstärkerschaltung
10' SC-Verstärkerschaltung
10" SC-Verstärkerschaltung
$C_L$ Umladekapazität
$C_R$ Rückkoppelkapazität
$C_S$ Eingangskapazität
12 Schaltungseingangsanschluss

14 Schaltungsausgangsanschluss

16 ersten Anschluss der Eingangskapazität

18 zweiten Anschluss der Eingangskapazität

20 nicht-invertierende Verstärkereingangsanschluss

22 Verstärker

24 Verstärkerausganganschluss

26 Rückkoppelnetzwerk

28 Wiederaufladequelle

30 Ladestromquelle

32 erste Anschluss der Umladekapazität

34 zweiten Anschluss der Umladekapazität

36 erster Anschluss der Rückkoppelkapazität

38 zweiten Anschluss der Rückkoppelkapazität

$S_1$ ersten Schalter

$S_2$ zweiter Schalter

$S_3$ dritten Schalter

$S_4$ Phase geschlossenen vierten Schalter

$S_5$ fünften Schalter

$S_6$ sechsten Schalter

$\Phi_1$ Steuersignal für die Schalter

$\Phi_2$ Steuersignal für die Schalter

**Patentansprüche**

1. SC-Verstärkerschaltung (10) zum Verstärken einer an einem Eingang anliegenden Eingangsspannung einer Messsignalquelle um einen Verstärkungsfaktor und zum Ausgeben der verstärkten Eingangsspannung an einem Ausgang während eines Schaltzyklus, der mindestens ein Aufladeintervall zum Aufladen einer Eingangskapazität ($C_S$) und mindestens ein Entladeintervall zum Entladen der Eingangskapazität ($C_S$) umfasst, wobei die SC-Verstärkerschaltung (10) versehen ist mit

- einem Schaltungseingangsanschluss (12) für die zu verstärkende, von der Messsignalquelle, gelieferten Eingangsspannung,
- einem Verstärker (22) mit einem Verstärkereingangsanschluss (20) und einem Verstärkerausgangsanschluss,
- wobei die Eingangskapazität ($C_S$) mit dem Verstärkereingangsanschluss (20) verbunden ist und in dem Aufladeintervall mit dem Schaltungseingangsanschluss (12) verbindbar sowie in dem Entladeintervall von dem Schaltungseingangsanschluss (12) entkoppelbar ist,
- einem Rückkoppelnetzwerk (26), das zwischen den Verstärkerausgangsanschluss (24) und den Verstärkereingangsanschluss (20) geschaltet ist, und
- einer Wiederaufladequelle (28) zum Bereitstellen eines Ladestroms zum Aufladen der Eingangskapazität ($C_S$), wobei die Wiederaufladequelle (28) in dem Aufladeintervall die Eingangskapazität ($C_S$) auflädt und in dem Entladeintervall hinsichtlich eines Aufladens der Eingangskapazität ($C_S$) wirkungslos geschaltet ist,
- wobei die Wiederaufladequelle (28) eine Umladekapazität ($C_L$) ist,

**dadurch gekennzeichnet,**

- **dass** die Wiederaufladequelle (28) einen mit dem Verstärkereingangsanschluss (20) verbundenen ersten Anschluss (32) und einen zweiten Anschluss (34) aufweist, der wechselweise entweder über einen dritten Schalter ($S_3$) mit dem Verstärkereingangsanschluss (20) oder über einen vierten Schalter ($S_4$) mit dem Verstärkerausgangsanschluss (24) verbindbar ist, und
- **dass** in dem Aufladeintervall der dritte Schalter ($S_3$) geschlossen sowie der vierte Schalter ($S_4$) offen und in dem Entladeintervall der dritte Schalter ($S_3$) offen sowie der vierte Schalter ($S_4$) geschlossen ist.

2. SC-Verstärkerschaltung (10) nach Anspruch 1, **gekennzeichnet durch** eine Rückkoppelkapazität ($C_R$), die einen mit dem Verstärkerausgangsanschluss (24) verbundenen ersten Anschluss (36) und einen zweiten Anschluss (38) aufweist, der wechselweise entweder über einen fünften Schalter ($S_5$) mit dem Verstärkereingangsanschluss (20) oder über einen sechsten Schalter ($S_6$) mit Masse verbindbar ist, wobei in dem Aufladeintervall der fünfte Schalter ($S_5$) geschlossen sowie der sechste Schalter offen und in dem Entladeintervall der fünfte Schalter ($S_5$) offen sowie

der sechste Schalter (S$_6$) geschlossen ist.

3.  SC-Verstärkerschaltung (10) nach Anspruch 1 oder 2, **dadurch gekennzeichnet, dass** die Eingangskapazität (C$_S$) einen mit dem Verstärkereingangsanschluss (20) verbundenen ersten Anschluss (16) und einen zweiten Anschluss (18) aufweist, der wechselweise entweder über einen ersten Schalter (S$_1$) mit dem Schaltungseingangsanschluss oder über einen zweiten Schalter (S$_2$) mit Masse verbindbar ist, wobei in dem Aufladeintervall der erste Schalter geschlossen sowie der zweite Schalter offen und in dem Entladeintervall der erste Schalter offen sowie der zweite Schalter geschlossen ist, und dass die Wiederaufladequelle (28) in dem Aufladeintervall Ladestrom in den zweiten Anschluss der Eingangskapazität (C$_S$) einspeist.

4.  Verfahren zum Betreiben einer SC-Verstärkerschaltung (10) zum Verstärken einer an einem Eingang anliegenden Eingangsspannung einer Messsignalquelle um einen Verstärkungsfaktor und zum Ausgeben der verstärkten Eingangsspannung an einem Ausgang während eines Schaltzyklus, der mindestens ein Aufladeintervall zum Aufladen einer Eingangskapazität (C$_S$) und mindestens ein Entladeintervall zum Entladen der Eingangskapazität (C$_S$) umfasst, **dadurch gekennzeichnet,**

    - **dass** die Eingangskapazität (C$_S$) in dem Aufladeintervall des Schaltzyklus mit Ladung aufgeladen wird, die durch eine außerhalb der Messsignalquelle und insbesondere innerhalb der SC-Verstärkerschaltung (10) angeordnete Wiederaufladequelle (28) erzeugt wird, und
    - **dass** die Wiederaufladequelle (28) eine Umladekapazität (C$_L$) ist, die einen mit dem Verstärkereingangsanschluss (20) verbundenen ersten Anschluss (32) und einen zweiten Anschluss (34) aufweist, der wechselweise entweder über einen dritten Schalter (S$_3$) mit dem Verstärkereingangsanschluss (20) oder über einen vierten Schalter (S$_4$) mit dem Verstärkerausgangsanschluss (24) verbindbar ist, wobei in dem Aufladeintervall der dritte Schalter (S$_3$) geschlossen sowie der vierte Schalter (S$_4$) offen und in dem Entladeintervall der dritte Schalter (S$_3$) offen sowie der vierte Schalter (S$_4$) geschlossen ist.

## Claims

1.  An SC amplifier circuit (10) for amplifying an input voltage, present at an input, of a measuring signal source by an amplification factor and for outputting the amplified input voltage to an output during a switching cycle which comprises at least one charging interval for charging an input capacitance (C$_S$) and at least one discharging interval for discharging said input capacitance (C$_S$), wherein said SC amplifier circuit (10) comprises

    - a circuit input terminal (12) for the input voltage to be amplified and supplied by said measuring signal source,
    - an amplifier (22) having an amplifier input terminal (20) and an amplifier output terminal (24),
    - wherein said input capacitance (C$_S$) is connected with said amplifier input terminal (20) and is adapted to be connected with said circuit input terminal (12) during the charging interval and is adapted to be decoupled from said circuit input terminal (12) during the discharging interval,
    - a feedback network (26) connected between said amplifier output terminal (24) and said amplifier input terminal (20), and
    - a recharging source (28) for providing a charging current for charging said input capacitance (C$_S$), wherein said recharging source (28) charges said input capacitance (C$_S$) during the charging interval and is made ineffective with regard to charging the input capacitance (C$_S$) during the discharging interval,
    - wherein said recharging source (28) is a charge capacitance (C$_L$),

    **characterized in that**

    - said recharging source (28) comprises a first terminal (32) connected with said amplifier input terminal (20), and a second terminal (34) which is adapted to be alternately connected with said amplifier input terminal (20) via a third switch (S$_3$) or with the amplifier output terminal (24) via a fourth switch (S$_4$), and
    - in the charging interval said third switch (S$_3$) is closed and said fourth switch (S$_4$) is open, and during the discharging interval said third switch (S$_3$) is open and said fourth switch (S$_4$) is closed.

2.  The SC amplifier circuit (10) according to claim 1, **characterized by** a feedback capacitance (C$_R$) comprising a first terminal (36) connected with the amplifier output terminal (24), and a second terminal (38) adapted to be alternately connected either with the amplifier input terminal (20) via a fifth switch (S$_5$) or with ground via a sixth switch (S$_6$), wherein during the charging interval said fifth switch (S$_5$) is closed and said sixth switch is open, and during the discharging interval said fifth switch ($S_5$) is open and said sixth switch ($S_6$) is closed.

3. The SC amplifier circuit (10) according to any one of claims 1 or 2, characterized that the input capacitance ($C_S$) comprises a first terminal (16) connected with the amplifier input terminal (20), and a second terminal (18) adapted to be alternately connected either with the circuit input terminal via a first switch ($S_1$) or with ground via a second switch ($S_2$), wherein during the charging interval said first switch is closed and said second switch is open, and during the discharging interval said first switch is open and said second switch is closed, and that the recharging source (28) feeds a charging current into said second terminal of said input capacitance ($C_S$) during the charging interval.

4. A method for operating an SC amplifier circuit (10) for amplifying an input voltage, present at an input, of a measuring signal source by an amplification factor and for outputting the amplified input voltage to an output during a switching cycle which comprises at least one charging interval for charging an input capacitance ($C_S$) and at least one discharging interval for discharging said input capacitance ($C_S$),

**characterized in that**

- said input capacitance ($C_S$) is charged with a charge during the charging interval of the switching cycle, said charge being generated by a recharging source (28) arranged outside said measuring signal source and in particular inside said SC amplifier circuit (10), and
- said recharging source (28) is a charge capacitance ($C_L$) comprising a first terminal (32) connected with the amplifier input terminal (20), and a second terminal (34) adapted to be alternately connected either with said amplifier input terminal (20) via a third switch ($S_3$) or with said amplifier output terminal (24) via a fourth switch ($S_4$), wherein during the charging interval said third switch ($S_3$) is closed and said fourth switch ($S_4$) is open, and during the discharging interval said third switch ($S_3$) is open and said fourth switch ($S_4$) is closed.

**Revendications**

1. Circuit amplificateur SC (10) destiné à l'amplification par un facteur d'amplification d'une tension d'entrée d'une source de signal de mesure, appliquée à une entrée, et à l'émission de la tension d'entrée amplifiée vers une sortie pendant un cycle de commutation comportant au moins un intervalle de charge pour la charge d'une capacité d'entrée ($C_s$) et au moins un intervalle de décharge pour la décharge de la capacité d'entrée ($C_s$), dans lequel le circuit amplificateur SC (10) est prévu avec

- une connexion d'entrée de circuit (12) pour la tension d'entrée à amplifier fournie par la source du signal de mesure,
- un amplificateur (22) doté d'une connexion d'entrée d'amplificateur (20) et d'une connexion de sortie d'amplificateur (24),
- dans lequel la capacité d'entrée (Cs) est raccordée à la connexion d'entrée d'amplificateur (20) et est raccordable à la connexion d'entrée de circuit (12) dans l'intervalle de charge et peut être aussi découplé de la connexion d'entrée de circuit (12) dans l'intervalle de décharge,
- un réseau de couplage rétroactif (26), connecté entre la connexion de sortie d'amplificateur (24) et la connexion d'entrée d'amplificateur (20), et
- une source de recharge (28) destinée à établir un courant de charge pour charger la capacité d'entrée ($C_s$), dans lequel la source de recharge (28) charge la capacité d'entrée ($C_s$) dans l'intervalle de charge et est commutée pour être inopérante en ce qui concerne une charge de la capacité d'entrée ($C_s$) dans l'intervalle de décharge,
- dans lequel la source de recharge (28) est une capacité de charge ($C_L$),

**caractérisé en ce que**

- la source de recharge (28) comporte une première connexion (32) raccordée à la connexion d'entrée d'amplificateur (20) et une deuxième connexion (34) qui est raccordable tour à tour soit avec la connexion d'entrée d'amplificateur (20) par le biais d'un troisième commutateur ($S_3$) soit avec la connexion de sortie d'amplificateur (24) par le biais d'un quatrième commutateur ($S_4$), et
- **en ce que**, dans l'intervalle de charge, le troisième commutateur (S3) est fermé et le quatrième commutateur ($S_4$) est ouvert, et dans l'intervalle de décharge, le troisième commutateur ($S_3$) est ouvert et le quatrième commutateur ($S_4$) est fermé.

**2.** Circuit amplificateur SC (10) selon la revendication 1, **caractérisé par** une capacité de couplage rétroactif ($C_R$), comportant une première connexion (36) raccordée à la connexion de sortie d'amplificateur (24) et une deuxième connexion (38), qui est raccordable tour à tour soit avec la connexion d'entrée d'amplificateur (20) par le biais d'un cinquième commutateur ($S_5$) soit avec la masse par le biais d'un sixième commutateur ($S_6$), dans lequel dans l'intervalle de charge, le cinquième commutateur ($S_5$) est fermé et le sixième commutateur ($S_6$) est ouvert, et dans l'intervalle de décharge, le cinquième commutateur ($S_5$) est ouvert et le sixième commutateur ($S_6$) est fermé

**3.** Circuit amplificateur SC (10) selon la revendication 1 ou 2, **caractérisé en ce que** la capacité d'entrée ($C_S$) comporte une première connexion (16) raccordée à la connexion d'entrée d'amplificateur (20) et une deuxième connexion (18), qui est raccordable tour à tour soit avec la connexion d'entrée de circuit par le biais d'un premier commutateur ($S_1$) soit avec la masse par le biais d'un deuxième commutateur ($S_2$), dans lequel dans l'intervalle de charge, le premier commutateur est fermé et le deuxième commutateur est ouvert, et dans l'intervalle de décharge, le premier commutateur est ouvert et le deuxième commutateur est fermé, et **en ce que** la source de recharge (28) injecte, dans l'intervalle de charge, du courant de charge dans la deuxième connexion de la capacité d'entrée ($C_S$).

**4.** Procédé de fonctionnement d'un circuit amplificateur SC (10) destiné à l'amplification, par un facteur d'amplification, d'une tension d'entrée d'une source de signal de mesure appliquée à une entrée et à l'émission de la tension d'entrée amplifiée vers une sortie pendant un cycle de commutation comportant au moins un intervalle de charge pour la charge d'une capacité d'entrée ($C_S$) et au moins un intervalle de décharge pour la décharge de la capacité d'entrée ($C_S$), **caractérisé en ce que**

- la capacité d'entrée ($C_S$) est chargée pendant l'intervalle de charge du cycle de commutation avec une charge, qui est produite par le biais d'une source de recharge (28) agencée à l'extérieur de la source de signal de mesure et en particulier agencée à l'intérieur du circuit amplificateur SC (10), et

**en ce que** la source de recharge (28) est une capacité de charge ($C_L$), comportant une première connexion (32) raccordée à la connexion d'entrée d'amplificateur (20) et une deuxième connexion (34), qui est raccordable tour à tour soit avec la connexion d'entrée d'amplificateur (20) par le biais d'un troisième commutateur ($S_3$) soit avec la connexion de sortie d'amplificateur (24) par le biais d'un quatrième commutateur ($S_4$), dans lequel, dans l'intervalle de charge, le troisième commutateur ($S_3$) est fermé et le quatrième commutateur ($S_4$) est ouvert, et dans l'intervalle de décharge, le troisième commutateur ($S_3$) est ouvert et le quatrième commutateur ($S_4$) est fermé.

Abtastschalter
mit Schaltfrequenz $f_s$
in Taktphase $\Phi_1$

Rücksetzschalter
mit Schaltfrequenz $f_s$
in Taktphase $\Phi_2$

$R_{SIG}$

$V_S$

$V_{SIG}$

$C_{FLT}$

$C_S$

vereinfachte Standard SC-Verstärker-Abtast-Stufe

$R_{SIG}$

$R_S$

$V_S$

$V_{SIG}$

$C_{FLT}$

$C_S$

Äquivalente Schaltung während der Abtastung

$R_{SIG}$

$V_S$

$V_{SIG}$

$C_{FLT}$

$R_{EQ}$

Abtastung mit Äquivalenz-Widerstand $R_{EQ}$

**Fig.1**

**Fig.2**

**Fig.3**

**Fig.4**

$\Phi_1$ ⊓_⊓_ ⋯ EIN AUS

$\Phi_2$ _⊓_⊓ ⋯ EIN AUS

10'

$V_{INP}$ ○— 18 $C_S$ 16
12 $\Phi_1$ ●—/—● ○—||—○ ————— $\Phi_1$ $\Phi_2$ 26
$S_1$

$\Phi_2$ | $S_2$
$V_{CM}$ optional ●—/—● ⊙ $\Phi_1$
conn. $Q=Q_{RD}$

Rückkoppel-netzwerk —— $V_{CM\_OPIN}$

20 22
$\Phi_2$ | $S_2'$ ●—/—● −
$V_{INN}$ ○— $S_1'$ 18' 16'
12 ●—/—● ○—||—○ + ○ $V_{OUTP}$ ○ $V_{CM}$
$\Phi_1$ $C_S'$ ○ $V_{OUTN}$
$V_{OFS}$ ⊙ 24 14

Rückkoppel-netzwerk —— $V_{CM\_OPIN}'$

$\Phi_1$ $\Phi_2$ 26'

**Fig.5**

10'

$\Phi_1 \triangleq$ EIN
$\Phi_2 \triangleq$ AUS

$V_{INP}$ ○— 18 $C_S$ 16
12 ●—●—● ○—||—○ ————— $\Phi_1$ $\Phi_2$ 26
$S_1$

| $S_2$
$V_{CM}$ optional ●—/—● ⊙
conn. $Q=Q_{RD}$

Rückkoppel-netzwerk —— $V_{CM\_OPIN}$

20 22
| $S_2'$ ●—/—● −
$V_{INN}$ ○— $S_1'$ 18' 16'
12 ●—●—● ○—||—○ + ○ $V_{OUTP}$ ○ $V_{CM}$
$C_S'$ ○ $V_{OUTN}$
$V_{OFS}$ ⊙ 24 14

Rückkoppel-netzwerk —— $V_{CM\_OPIN}$

$\Phi_1$ $\Phi_2$ 26'

**Fig.6**

**Fig.7**

**Fig.8**

$\Phi_1 \triangleq$ EIN
$\Phi_2 \triangleq$ AUS

Fig.9

$\Phi_1 \triangleq$ EIN
$\Phi_2 \triangleq$ AUS

Fig.10

**IN DER BESCHREIBUNG AUFGEFÜHRTE DOKUMENTE**

**In der Beschreibung aufgeführte Patentdokumente**

- WO 9610827A1 A

**In der Beschreibung aufgeführte Nicht-Patentliteratur**

- **DAVID A. JOHNS ; KEN MARTIN.** Analog Intergrated Circuit Design. John Wiley & Sons, Inc, 1997, 431